# EUROPEAN PATENT SPECIFICATION

(11) **EP 2 894 957 B1**
(45) Date of publication and mention of the grant of the patent: **14.12.2022**
(21) Application number: 12884022.0
(22) Date of filing: 10.09.2012
(51) Int. Cl.: H05K 13/04

(54) **LEAD CORRECTION METHOD AND LEAD CORRECTION DEVICE**
LEITERKORREKTURVERFAHREN UND LEITERKORREKTURVORRICHTUNG
PROCÉDÉ DE CORRECTION DE BROCHE ET DISPOSITIF DE CORRECTION DE BROCHE

(43) Date of publication of application: 15.07.2015
(73) Proprietor: Fuji Corporation, Chiryu-shi, Aichi 472-8686 (JP)
(72) Inventor: IWAKI, Noriaki, Chiryu, Aichi 472-8686 (JP)
(74) Representative: Grünecker Patent- und Rechtsanwälte PartG mbB
(86) International application number: PCT/JP2012/073083
(87) International publication number: WO 2014/038087

(56) References cited:
- JP-A- H0 541 593
- JP-A- H0 541 593
- JP-A- H0 637 492
- JP-A- H03 278 600
- JP-A- H06 112 691
- JP-B2- 3 192 773
- US-A- 5 219 404
- US-A- 5 777 886

## Description

### Technical Field

The present invention relates to a lead correction method and a lead correction device which are used in a component mounting device which can mount a component with leads on a printed circuit board.

### Background Art

A method which corrects a terminal pin position so that the terminal pin position of an electronic component is inserted into a pin insertion hole of a printed circuit board is disclosed in PTL 1. In PTL 1, the electronic component is supplied to a correction portion, the terminal pin position is corrected, the corrected electronic component is transported to the component insertion position by an insertion head, the terminal pin position is measured by a laser measurement instrument, and when the result is that the measured value exceeds an allowable range, the correction is repeated again.

PTL 2 discloses a lead conditioning system that conditions leads of an electronic component package and includes a rotary table for holding the electronic component package and making accessible the leads. A conditioning tool includes a conditioner arm and a conditioner blade that selectively contacts a predetermined number of the leads. A manipulator moves the conditioning tool to positions that contacts the predetermined number of the leads to condition the leads. A control system controls the operation of manipulator.

PTL 3 proposes a method wherein a height position of a lead of a component is corrected and then recognized again visually and the component is installed. First, a component installation head positioned at a station of a rotary head part is made to take up a component by suction from a component supply set of a component supply part and, with an index table rotated intermittently, the head is made to transfer the component to a station. Then, a lift of a lead of the component is determined, and when the lift of the lead is present, the component is transferred to a station so that the lead be corrected. Thereafter the component is transferred to the station again and it is checked up on the basis of the average height whether the correction of the lead is executed as intended, by operating an image pickup unit. In the case when no lift of the lead is present, the component is fitted on a board from the component installation head at a station with an X-Y table part moved. In the case when the lift of the lead is present, the correction is executed by a lead correcting unit. PTL 3 discloses a lead correction method according to the preamble of independent claim 1.

PTL 4 proposes to provide a simple correcting operation and to eliminate a damage of a lead in a method and an apparatus for correcting leads of a surface mounting type component and particularly a DIP (dual in-line package) component. Leads of a surface mounting type component are held in an aligned state in an alignment block formed of a lower block and an upper block, and motions for bending the leads until roots of the leads are plastically deformed in either upward or downward direction and returning them, are applied to the block.

### Citation List

### Patent Literature

PTL 1: JP-A-2-81500
PTL 2: US 5 777 886 A
PTL 3: JP 3 192773 B2
PTL 4: JP H05 41593 A

### Summary of Invention

### Technical Problem

In PTL 1, an electronic component is fixed by fixing claws 158 and 159 provided on a correction portion before the electronic component is inserted into a printed circuit board, and a terminal pin position is corrected by moving a blade 155 in the fixed state. Accordingly, the correction operation is also performed on an electronic component in which the correction of the terminal pin position is not needed, and when the correction is repeated again after the measurement, it is necessary to set the electronic component held by an insertion head to the correction portion again, and thus, it is not possible to efficiently perform the correction of the terminal pin position.

Moreover, generally, since a terminal pin has elasticity, only a portion of a deformation amount is permanent deformation even when the terminal pin is deformed by the correction operation, and thus, according to a curved state of the terminal pin position, it may be difficult to make the terminal pin position be within an allowable range even when the correction operation is repeated.

The present invention is made in consideration of the problems of the related art, and an object thereof is to provide a lead correction method and a lead correction device for efficiently performing the correction of lead positions of a component with leads.

### Solution to Problem

A lead correction method according to the invention is defined in independent claim 1. A preferred embodiment of the lead correction method is set out in dependent claim 2.

### REPLACEMENT SHEET

In addition, a lead correction device according to the invention is defined in independent claim 3. Preferred embodiments of the lead correction device are set out in the dependent claims 4 to 7.

### Advantageous Effects of Invention

According to the invention of the above-described lead correction method, since a correction cycle which corrects the position of the lead is repeated up to the number of allowable times of correction operation which is set in advance, it is possible to correct the lead position so as to be within the allowable tolerance, the correction of the lead position is not repeated endlessly, and it is possible to efficiently correct the lead position.

In addition, according to the invention of the above-described lead correction device, since the correction unit including the forming die which corrects the position of the lead and the drive unit which moves the forming die is detachably mounted on the correction station, it is possible to deal with a component with leads having a different shape simply by replacing the correction unit installed at the correction station.

### Brief Description of Drawings

[Fig. 1] Fig. 1 is a schematic plan view showing the entirety of a component mounting device according to an embodiment of the present invention.
[Fig. 2] Fig. 2 is a view showing a lifting shaft which is held by a component mounting head.
[Fig. 3] Fig. 3 is a perspective view showing an example of a component with leads.
[Fig. 4] Fig. 4 is a schematic view showing a correction unit supporting stand.
[Fig. 5] Fig. 5 is a perspective view showing an example of a correction unit which is installed in a correction station.
[Fig. 6] Fig. 6 is a perspective view showing the details of the correction unit.
[Fig. 7] Fig. 7 is a block diagram showing a control device which controls a component mounting device.
[Fig. 8] Fig. 8 is a view showing a disposition relationship with respect to a reference position of the correction unit.
[Fig. 9] Fig. 9 is a flowchart showing a procedure of a lead correction method.
[Fig. 10] Fig. 10 is a view showing the disposition relationship with respect to the reference position of the correction unit when a plurality of kinds of correction units are attached.

### Description of Embodiments

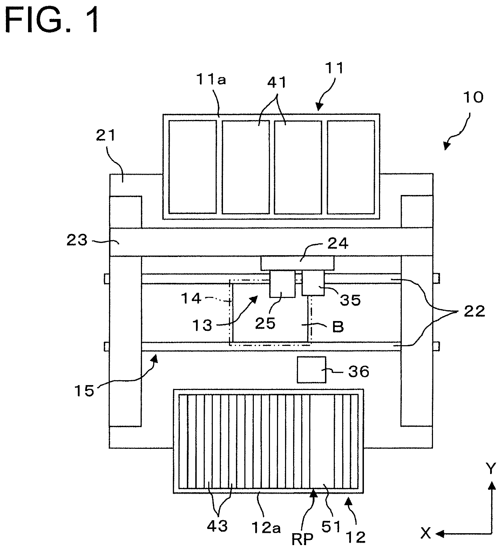

Hereinafter, an embodiment of the present invention will be described with reference to the drawings. Fig. 1 shows the entire plan view of a component mounting device 10, and the component mounting device 10 includes a tray type component supply device 11, a feeder type component supply device 12, a component transfer device 13, a substrate holding device 14, and a substrate transport device 15.

The substrate transport device 15 is provided on a base 21 of the component mounting device 10 and includes a belt conveyor (not shown) which transports a printed circuit board B along transport rails 22, and the substrate transport device transports the printed circuit board B along the transport rails 22, carries the printed circuit board onto the substrate holding device 14, and carries the printed circuit board out of the substrate holding device 14. In Fig. 1, a transport direction of the printed circuit board B is defined as an X axis direction, and a direction perpendicular to the X axis direction is defined as a Y axis direction. Although it is not shown, the substrate holding device 14 includes a substrate support device which supports the printed circuit board B and a clamping device which clamps the printed circuit board B.

The component transfer device 13 is configured of an XY robot, and includes a Y axis movable carriage 23 which is supported so as to be movable in the Y axis direction at a position above the base 21, an X axis movable carriage 24 which is supported so as to be movable in the X axis direction on the Y axis movable carriage 23, and a component mounting head 25 which is attached to the X axis movable carriage 24. The movements of the X axis movable carriage 24 and the Y axis movable carriage 23 are controlled in the X axis direction and the Y axis direction by an X axis servo motor (not shown) and a Y axis servo motor (not shown).

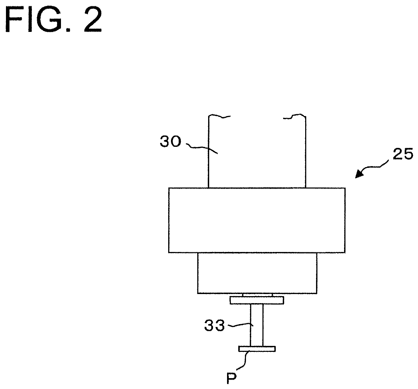

As shown in Fig. 2, in the component mounting head 25, a lifting shaft 30 is supported so as to be lifted and lowered in an up-down direction (Z axis direction) orthogonal to the X axis direction and the Y axis direction and to be rotatable around a Z axis line. A movement in the Z axis direction and a rotation angle of the lifting shaft 30 are controlled by a Z axis servo motor (not shown) and an θ axis servo motor (not shown). An suction nozzle 33 which suctions an electronic component P or a chuck (not shown) which holds the electronic component P with leads is detachably mounted on the lifting shaft 30. The suction nozzle 33 and the chuck are stored at a predetermined position on the base 21 and are mounted on the appropriate lifting shaft 30.

In Fig. 1, a substrate imaging device 35 configured of a CCD camera is attached to the X axis movable carriage 24, and the substrate imaging device 35 images a reference mark and a substrate ID mark provided on the printed circuit board B positioned on the substrate holding device 14 and acquires substrate position reference information and substrate ID information. In addition, the positions of the component mounting head 25 in the XY directions with respect to the printed circuit board B are corrected based on the substrate position reference information acquired by the substrate imaging device 35, and the mounting operation of the electronic component P is controlled based on the substrate ID information.

Moreover, a component imaging device 36 configured of a CCD camera which images the electronic component P (the leads of the electronic component with leads) suctioned or held by the suction nozzle 33 or the chuck from below is provided on the base 21. The component imaging device 36 images the electronic component P held by the component mounting head 25 while the electronic component is moved from the component supply devices 11 and 12 to the printed circuit board B, detects misalignment, angle deviation, or the like of the electronic component P with respect to a center of the suction nozzle 33 or detects the (inclined or curved) position of the lead of the electronic component P with leads held by the chuck, and corrects a movement amount in the XY directions or the like of the component mounting head 25 or performs the correction of the lead position based on the detected results.

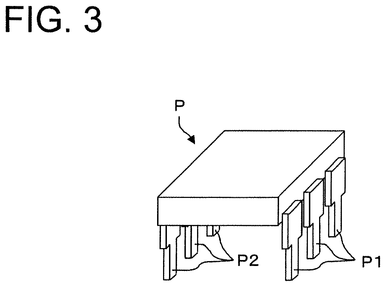

Fig. 3 shows an example of the electronic component P with leads, and a plurality of leads P1 and P2 protrude downward on both sides of the component P with leads. Two rows of leads P1 and P2 are separated from each other and arranged in straight lines. The leads P1 and P2 of the component P with leads are inserted into lead insertion holes (not shown) which are formed on the printed circuit board B. The leads P1 and P2 inserted into the lead insertion holes are bent by a lead bending device (not shown) which is disposed below the printed circuit board B, and thus, the component P with leads is fixed to the printed circuit board B.

In Fig. 1, the tray type component supply device 11 and the feeder type component supply device 12 are apart from each other in the Y axis direction and are provided on both sides of the substrate transport device 15. A plurality of trays 41 which accommodate the component P with leads are detachably mounted on the device stand 11a of the tray type component supply device 11.

Meanwhile, in the feeder type component supply device 12, a plurality of tape feeders 43 which supply the taped electronic component P are detachably mounted on the device stand 12a, and the plurality of tape feeders 43 are juxtaposed in the X axis direction and are mounted on a plurality of slots formed on the device stand 12a.

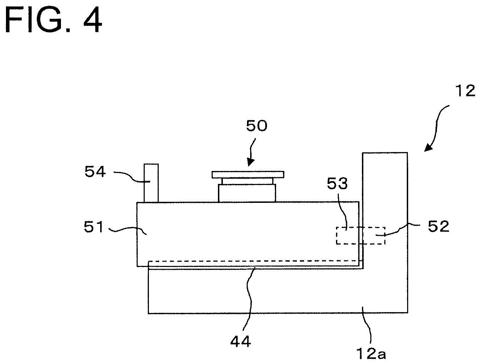

As shown in Fig. 1, a correction unit supporting stand 51 is detachably mounted between the plurality of tape feeders 43 in a predetermined slot 44 (refer to Fig. 4) which is formed on the device stand 12a of the feeder type component supply device 12. The correction unit supporting stand 51 configures a correction station RP on which a correction unit 50 for correcting the positions (inclination) of the leads P1 and P2 of the component P with leads is detachably mounted.

As shown in Fig. 4, a communication connector 53 which can be connected to a communication connector 52 provided on the device stand 12a is provided on the tip portion of the correction unit supporting stand 51. In addition, although it is not shown, a positioning pin which can engage with a positioning hole formed on the device stand 12a is provided on the tip portion of the correction unit supporting stand 51.

The correction unit supporting stand 51 is positioned at a predetermined position along the slot 44 of the device stand 12a, and thus, the communication connector 53 of the correction unit supporting stand 51 is connected to the communication connector 52 of the device stand 12a. Accordingly, electrical power is supplied from the device stand 12a side to the correction unit supporting stand 51 side, and thus, required information can be communicated.

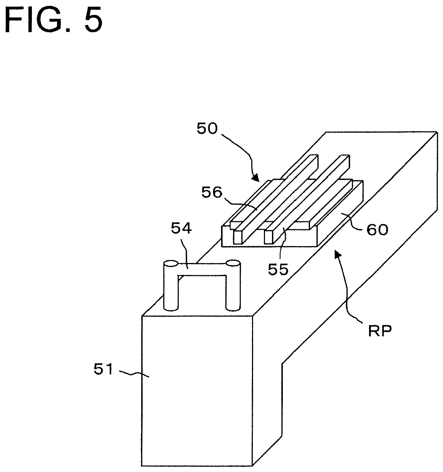

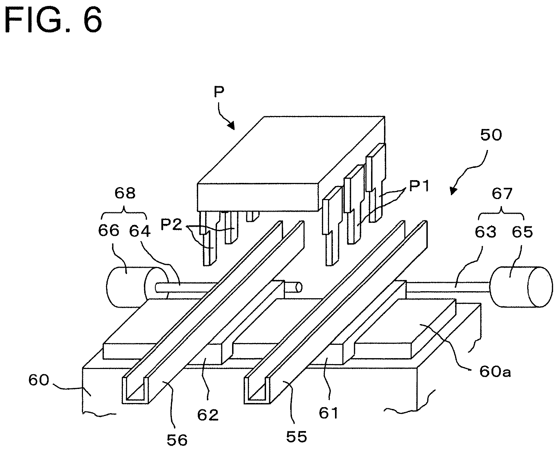

As shown in Figs. 5 and 6, the correction unit 50 which is detachably mounted on the correction unit supporting stand 51 includes two (first and second) forming dies 55 and 56 which correct inclinations of the leads P1 and P2 at positions at which the leads can be inserted into the lead insertion holes (not shown) formed on the printed circuit board B, and are parallel to each other. The first and second forming dies 55 and 56 are separated from each other in the X axis direction, and are juxtaposed so as to be parallel to each other on both sides of a center portion in a state where the center position of the correction unit 50 is interposed therebetween. As shown in detail in Fig. 6, the first and second forming dies 55 and 56 have U shapes in which the upper portions are open, and extend thinly in the Y axis direction. A groove width and a length in the Y axis direction in the U shape of each of the first and second forming dies 55 and 56 are set to accommodate all leads P1 and P2 which exist in the Y axis direction of the component P with leads.

A base 60 of the correction unit 50 is detachably disposed on the correction unit supporting stand 51. First and second movable bodies 61 and 62 are supported so as to be guided in a movable manner in the X axis direction on a guide surface 60a formed on the base 60, and the first and second forming dies 55 and 56 are detachably attached to the first and second movable bodies 61 and 62.

First and second ball nuts (not shown) are attached to the first and second movable bodies 61 and 62, and first and second ball screws 63 and 64 screwed to the ball nuts are supported to the base 60 so as to be rotatable around the axis line parallel to the X axis direction. The first and second ball screws 63 and 64 are rotatably driven by first and second drive motors 65 and 66 installed on the base 60, and when the first and second drive motors 65 and 66 are driven, the first and second forming dies 55 and 56 are moved in the X axis direction with respect to the base 60 via a ball screw mechanism (first and second ball screws 63 and 64, and first and second ball nuts).

According to the first and second drive motors 65 and 66 and the ball screw mechanism driven by the drive motors 65 and 66, drive units 67 and 68 which move the first and second forming dies 55 and 56 are configured.

Accordingly, in the state where two rows of leads P1 and P2 protruding from the component P with leads are inserted into the first and second forming dies 55 and 56, the first and second forming dies 55 and 56 are moved in the same direction or the reverse direction in the X axis direction by the drive units 67 and 68, and thus, two rows of leads P1 and P2 are deformed by the first and second forming dies 55 and 56, and the lead positions are corrected.

Moreover, an encoder (not shown) is connected to the first and second drive motors 65 and 66, the rotation positions of the first and second drive motors 65 and 66, that is, the current positions of the first and second forming dies 55 and 56 are detected by the encoder, and the current positions are stored in a storage unit (RAM) of the control device described below. Accordingly, it is possible to freely change the positions of the first and second forming dies 55 and 56 according to a gap between two rows of leads P1 and P2 of the component P with leads.

As described above, by dividing the correction unit 50 into the drive units 67 and 68 and the forming dies 55 and 56, it is also possible to deal with a component P with leads having a different shape simply by exchanging the forming dies 55 and 56.

Moreover, a reference numeral 54 of Figs. 4 and 5 indicates a handle attached to the correction unit supporting stand 51, and the correction unit supporting stand 51 is attached to and detached from the slot 44 of the device stand 12a of the feeder type component supply device 12 using the handle 54.

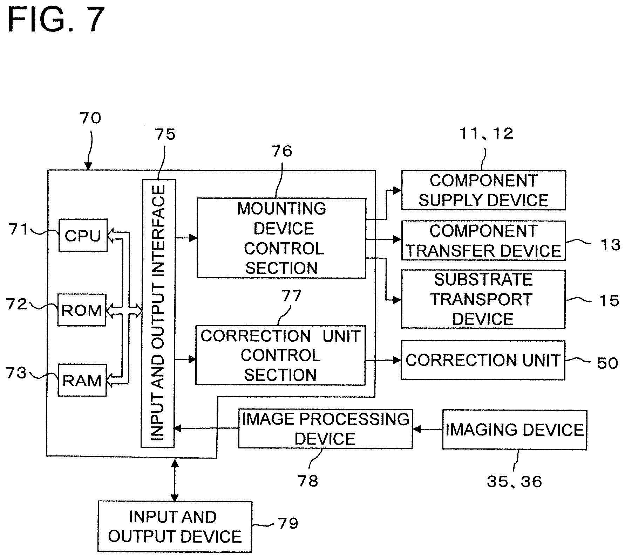

The component mounting device 10 is controlled by a control device 70 shown in Fig. 7. The control device 70 includes a CPU 71 which is a central processing unit, a ROM 72 and a RAM 73 which are storage units, and an input and output interface 75. A mounting device control section 76 which controls the component supply device 11 and 12, the component transfer device 13, the substrate transport device 15, or the like, a correction unit control section 77 which controls the correction unit 50, an image processing device 78 which processes the image data imaged by the substrate imaging device 35 and the component imaging device 36, or the like is connected to the input and output interface 75.

In addition, an input and output device 79 including an input section and a display section which inputs various data or the like is connected to the input and output interface 75, and various data required for the correction of the lead position, for example, data of a number of allowable times of correction operation (A1) or an allowable value (±σ1) of the lead position described below is input via the input and output device 79.

A basic program for mounting or inserting the electronic component P into the printed circuit board B and a program for controlling a sequence operation of the component mounting head 25 or the like are stored in the ROM 72. In addition, component data required for correcting the lead position of the component P with leads, correction unit data, and forming die data are stored in the RAM 73. The data is configured of a data structure shown in Table 1 below.

**[Table 1]**

| Data Table | |
|---|---|
| (1) Component Data | |
| | Component Name |
| | Lead Normal Position |
| | Lead Position Allowable Value (±σ1) |
| | Number of Allowable times of Correction Operation (A1) Bending Margin |
| | Forming Die Name |
| (2) Correction Unit Data | |
| | Forming Die Name |
| | Forming Die Attachment Position (O1) |

That is, as the component data, a name (for example, AAA, BBB, CCC, ...) of the component P with leads, normal position data of each of the leads P1 and P2 of the component P with leads, data of the allowable value ±σ1 in the position of each of the leads P1 and P2, data of the number of allowable times of correction operation A1 which is arbitrarily set, data with respect to a bending margin of each of the leads P1 and P2 during the correction operation, and a name of the forming die are made into databases.

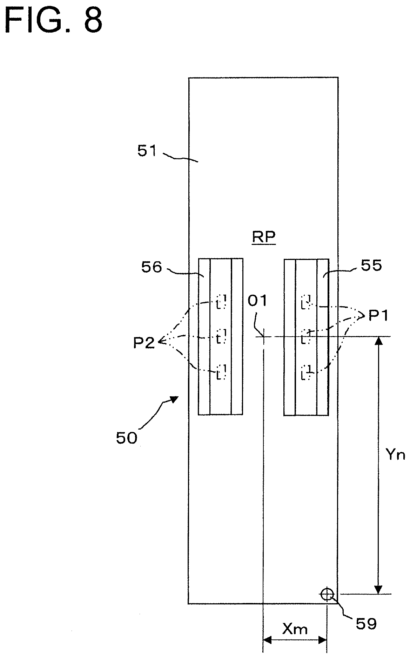

In addition, as the correction unit data, data of the name of the forming die and the attachment positions of the forming dies 55 and 56 is made into databases. As shown in Fig. 8, the data of the attachment position of the forming die indicates coordinates of the attachment position (center attachment position) O1 of the correction unit 50 attached to the correction unit supporting stand 51, and the coordinates of the attachment position are defined as an amount (Xm, Yn) of offset from a machine origin 59 of the correction unit 50 itself which is determined in advance. In addition, the machine origin 59 is offset by a predetermined amount in the X axis direction and the Y axis direction from the machine origin of the component mounting device 10.

Accordingly, by positioning the component mounting head 25 so that the center of the component P with leads held by the chuck of the component mounting head 25 is coincident with the attachment position O1 of the correction unit 50 on the correction unit supporting stand 51, the two rows of leads P1 and P2 of the component P with leads can be positioned at positions at which the leads can be inserted into grooves of the forming dies 55 and 56.

In this case, apart from the attachment position O1 of the correction unit 50, the specific position of the lead with respect to the center of the component P with leads is made into databases as the coordinates of the lead position, and it is also possible to position the component P with leads with respect to the forming dies 55 and 56 so that the specific position of the lead is determined based on the coordinates of the lead position.

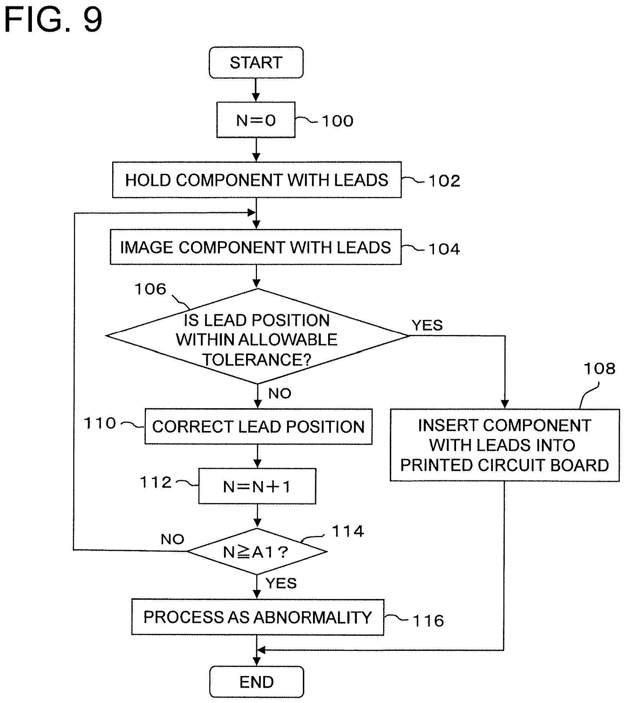

Next, a lead correction method which corrects the lead position of the component P with leads will be described with reference to a flowchart of Fig. 9. In addition, when the leads P1 and P2 of the component P with leads are inserted into the printed circuit board B, the chuck (not shown) is attached to the lifting shaft 30 of the component mounting head 25.

First, in Step 100, a content N of a counter which counts the number of times of the correction operation (correction cycles) is reset to 0. Subsequently, in Step 102, a predetermined component P with leads accommodated in the tray 41 of the tray type component supply device 11 is held by the chuck attached to the lifting shaft 30 of the component mounting head 25 in a state where the two rows of leads P1 and P2 oppose each other in the X axis direction and face downward.

When the component P with leads is held by the chuck, the component mounting head 25 is moved in XY directions, and the component P with leads held by the chuck is positioned at a position above the component imaging device 36. In this state, the leads P1 and P2 of the component P with leads are imaged by the component imaging device 36, and the captured image is processed by the image processing device 78 (Step 104).

Subsequently, in Step 106, a positional deviation amount and a position deviation direction (+ direction or - direction in the X axis direction) of each of the leads P1 and P2 with respect to the normal position are calculated based on the image processing, and are stored in the RAM 73 of the control device 70. In addition, the positional deviation amount of each of the leads P1 and P2 is compared with the allowable value (allowable tolerance) ±σ1 of the lead position stored in the RAM 73, and it is determined whether or not the lead position is within the range of the allowable tolerance. When the lead position is within the allowable tolerance (the determination result is YES), processing proceeds to Step 108, and in Step 108, an insertion operation in which the leads P1 and P2 of the component P with leads are inserted into the printed circuit board B which is clamped so as to be positioned on the substrate holding device 14 is performed.

That is, the component mounting head 25 is moved in the XY directions, the component P with leads held by the chuck is moved above the printed circuit board B, and in this state, the lifting shaft 30 is lowered, and the leads P1 and P2 of the component P with leads held by the chuck are inserted into the lead insertion holes (not shown) formed on the printed circuit board B.

In this case, since the positions of the leads P1 and P2 of the component P with leads are within the allowable tolerance, it is possible to smoothly insert the leads P1 and P2 into the lead insertion holes of the printed circuit board B. When the leads P1 and P2 are inserted into the lead insertion holes of the printed circuit board B, the leads P1 and P2 are bent by the lead bending device (not shown) disposed below the printed circuit board B, and thus, the component P with leads is mounted so as to be fixed to the printed circuit board B.

On the other hand, when the determination result in Step 106 is NO (when the lead position is outside the range of the allowable tolerance ±σ1), processing proceeds to Step 110. In addition, in Step 110, the correction operation in which the lead position is corrected is performed.

That is, the component mounting head 25 is moved in XY directions, and the center of the component P with leads held by the chuck is positioned at the position at which the center is coincident with the attachment position O1 of the correction unit 50 on the correction unit supporting stand 51 which is mounted on the specific slot 44 of the feeder type component supply device 12. At this time, since the attachment position O1 of the correction unit 50 is disposed at the position offset by the predetermined amount (Xm, Yn) from the machine origin 59 of the correction unit 50 itself, it is possible to correctly position the center of the component P with leads held by the chuck at the position at which the center is coincident with the attachment position O1 of the correction unit 50 based on the position data.

When the component P with leads held by the chuck is positioned at the position above the correction unit 50, the lifting shaft 30 of the component mounting head 25 is lowered, and the two rows of leads P1 and P2 of the component P with leads are inserted into the grooves of the first and second forming dies 55 and 56 of the correction unit 50. Subsequently, the drive motors 65 and 66 are driven, and the first and second forming dies 55 and 56 are relatively moved in the X axis direction via the ball screw mechanism.

In this case, since the position deviation directions in the two rows of leads P1 and P2 of the component P with leads are stored in the RAM 73 according to the processing of the above-described Step 104, the drive directions of the drive motors 65 and 66 are determined based on the storage contents, and the first and second forming dies 55 and 56 are moved in the direction in which the lead position is corrected. At this time, driving amounts of the drive motors 65 and 66, that is, the movement amounts of the first and second forming dies 55 and 56 can be determined according to the positional deviation amounts of the leads P1 and P2 stored in the RAM 73.

The leads P1 and P2 engage with inner walls of the grooves in the first and second forming dies 55 and 56 by movements of the first and second forming dies 55 and 56, the leads P1 and P2 are deformed, and thus, the positions (inclinations) of the leads P1 and P2 are corrected.

When the correction operation of the determined lead position ends, in Step 112, "1" is added to the content N of the counter which counts the number of times of the correction operation, and subsequently, in Step 114, it is determined whether or not the content N of the counter has reached the number of allowable times of correction operation A1 stored in the RAM 73.

When the content N of the counter has not reached the number of allowable times of correction operation A1 (the determination result is NO), processing returns to Step 104 described above, the leads P1 and P2 of the component P with leads are imaged by the component imaging device 36 again, and it is determined whether or not the positional deviation amounts of the leads P1 and P2 are within the range of the allowable tolerance (Step 104 and Step 105). In addition, when the amounts are within the allowable range, the insertion operation of the component P with leads with respect to the printed circuit board B is performed, and when the amounts are not within the allowable range, the above-described correction cycle is repeated.

In Step 114, when it is determined that the content N of the counter has reached the number of allowable times of correction operation A1 by repeating the correction operations, processing with respect to abnormality is performed in Step 116.

That is, even when the correction operations have been performed the number of allowable times of correction operation A1, if the lead position is not within the range of the allowable tolerance, the component P with leads is discarded at a predetermined position as an abnormality, the next component P with leads is newly picked up from the tray 41 of the tray type component supply device 11, and the above-described operations are continued. Alternatively, as one method of the processing with respect to the abnormality, the component mounting device 10 is stopped, and an operator may be informed of the abnormality.

The imaging step of the lead correction method is configured by the above-described Step 104, and the determination step and the correction step of the lead correction method are configured by Step 106 and Step 110.

By repeating the correction cycle (imaging step, the determination step, and the correction step), only the component P with leads in which the lead position is correctly corrected can be inserted into the printed circuit board B, and the correction of the lead position is not performed endlessly.

In addition, since it is possible to change strokes of the first and second forming dies 55 and 56 by the first and second drive motors 65 and 66, it is possible to arbitrarily change the bending margins of the leads P1 and P2 during the forming, and for example, the program is carried out so that the bending margins of the leads P1 and P2 are changed according to the inclination (bending) amount of the lead position. In addition, the positions of the leads P1 and P2 after the correction and the length in the strokes of the first and second forming dies 55 and 56 in the previous correction operation are stored, and in the next and succeeding correction operation, a learning function for optimizing the length of the stroke may be provided. Accordingly, the leads P1 and P2 may be corrected more efficiently.

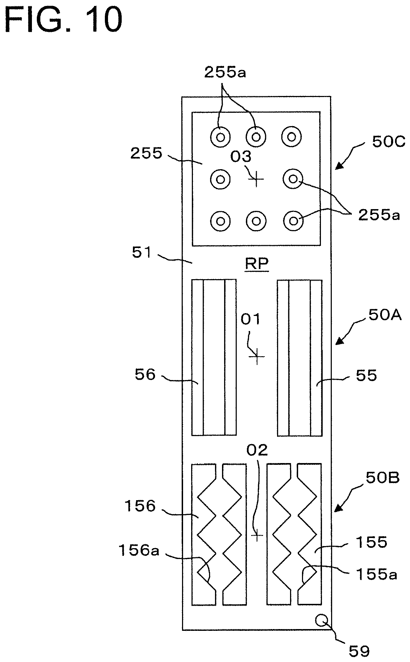

Fig. 10 shows an example in which three correction units 50A, 50B, and 50C of kinds different from one another are disposed on the correction unit supporting stand 51 at intervals in the Y axis direction and the space required for a plurality of kinds of forming shapes can be reduced.

That is, the first correction unit 50A having the same configuration as the correction unit 50 having the above-described first and second forming dies 55 and 56 is disposed at the center position in the Y axis direction on the correction unit supporting stand 51. The second correction unit 50B including first and second forming dies 155 and 156 having shapes different from the forming dies 55 and 56 of the first correction unit 50A is disposed on one end side of the first correction unit 50A. In addition, the third correction unit 50C including a forming die 255 on which a plurality of forming holes 255a are formed is disposed on the other end side of the first correction unit 50A.

In the second correction unit 50B, the faces opposing in the X axis directions of the first and second forming dies 155 and 156 are formed in V shapes 155a and 156a so that the two rows of leads P1 and P2 of the component P with leads are simultaneously corrected not only in the X axis direction but also in the Y axis direction, and a plurality of the V shapes 155a and 156a are formed along the Y axis direction.

In addition, although it is not shown, similar to the first correction unit 50A, the second correction unit 50 also includes a base which is detachably mounted on the correction unit supporting stand 51, and first and second movable bodies which are supported so as to be movable on the base and are moved by the ball screw mechanism, and the first and second forming dies 155 and 156 are detachably attached to the first and second movable bodies.

In addition, the third correction unit 50C is a correction unit which is suitable when the leads of the component P with leads are arranged in three rows or more in the X axis direction or when the leads are randomly arranged. In the third correction unit 50C, the forming die 255, on which the plurality of forming holes 255a corresponding to the arrangement position of each lead of the component P with leads are vertically formed, is detachably mounted on a base (not shown) which is detachably attached to the upper surface of the correction unit supporting stand 51.

The plurality of forming holes 255a of the forming die 255 of the third correction unit 50C are formed so that a diameter of the holes gradually decreases toward the lower portion. Accordingly, the plurality of leads of the component P with leads are inserted into the plurality of forming holes 255a, and in this state, each lead deeply enters the forming hole 255a, and thus, the leads are corrected so as to be coincident with the arrangement of the forming holes 255a.

Table 2 shows a data table corresponding to the three correction units 50A, 50B, and 50C shown in Fig. 10, and along with the same component data as Table 1, as the correction unit data, attachment positions O2 and O3 of the second and third correction units 50B and 50C are made into databases in addition to the attachment position O1 of the first correction unit 50A.

**[Table 2]**

| Data Table | |
|---|---|
| (1) Component Data | |
| | Component Name |
| | Lead Normal Position |
| | Lead Position Allowable Value (±σ1) |
| | Number of Allowable times of Correction Operation (A1) Bending Margin |
| | Forming Die Name |
| (2) Correction Unit Data | |
| | First Forming Die Name |
| | First Forming Die Attachment Position (O1) |
| | Second Forming Die Name |
| | Second Forming Die Attachment Position (O2) |
| | Third Forming Die Name |
| | Third Forming Die Attachment Position (O3) |

According to the example shown in Fig. 10, it is possible to cope with a plurality of components P with leads having kinds different from one another by providing the plurality of (three) correction units 50A, 50B, and 50C of kinds different from one another, and it is possible to reduce the space required for various forming shapes by disposing the plurality of correction units 50A, 50B, and 50C on one correction unit supporting stand 51.

In the above-described embodiment, the example in which one correction unit supporting stand 51 is mounted on the feeder type component supply device 12 is described. However, if necessary, the plurality of correction unit supporting stands 51 may be mounted on the feeder type component supply device 12. In this case, a plurality of kinds of correction units may detachably be attached to the plurality of correction unit supporting stands 51.

Moreover, in the above-described embodiment, the example is described in which the correction unit 50 (50A, 50B, and 50C) is detachably attached to the correction unit supporting stand 51 which is detachably mounted on the feeder type component supply device 12, as the correction station RP. However, the present invention is not limited to the example in which the correction unit 50 is attached to the correction unit supporting stand 51, and the correction unit 50 may be detachably attached to the base 21.

In addition, in the above-described embodiment, the example is described, which is applied to the component mounting device 10 in which the tray type component supply device 11 and the feeder type component supply device 12 are provided, and the component is mounted on the printed circuit board or the leads are inserted into the printed circuit board while the suction nozzle suctioning the component and the chuck holding the component with leads are replaced. However, of course, the present invention may be applied to a lead insertion device in which only the leads of the component with leads are inserted into the printed circuit board.

According to the above-described embodiment, the imaging step (Step 104) of imaging leads P1 and P2 of the component P with leads inserted into the lead insertion holes of the printed circuit board B, the determination step (Step 106) of determining whether or not positions of the leads P1 and P2 imaged in the imaging step are within the allowable tolerance in which the leads can be inserted into the lead insertion holes, and the correction step (Step 110) of correcting the positions of the leads P1 and P2 when it is determined that the positions are outside the allowable tolerance in the determination step are provided, in which the imaging step (Step 104) and the determination step (Step 106) are performed again after the correction operation in the correction step (Step 110), and when the lead positions are not corrected so as to be within the allowable tolerance, the imaging step (Step 104), the determination step (Step 106), and the correction step (Step 110) are repeated up to the number of allowable times of correction operation A1 which is maximally set in advance.

According to this lead correction method, the lead position is correctly corrected, and it is possible to accurately insert the leads of the component P with leads into the lead insertion holes of the printed circuit board B. Moreover, by setting the number of allowable times of correction operation A1, the lead position is not corrected endlessly, and thus, it is possible to efficiently perform the insertion operation of the component P with leads.

Moreover, when the lead positions are not within the allowable tolerance even when the correction operations have been repeated the number of allowable times of correction operation A1, the component P with leads is discarded as an abnormality, and thus, it is possible to continuously perform the mounting operation of the components P with leads without interrupting the mounting operation.

According to the above-described embodiment, the component imaging device 36 which images leads P1 and P2 of the component P with leads inserted into the lead insertion holes of the printed circuit board B, and the correction unit 50 which corrects the positions of the leads P1 and P2 when it is determined that the positions of the leads P1 and P2 imaged by the component imaging device 36 are outside the range of the allowable tolerance in which the leads can be inserted into the lead insertion holes are provided, in which the correction unit 50 includes the two forming dies 55 and 55 which correct the positions of the leads P1 and P2 and the drive units 57 and 58 which move the forming dies 55 and 56, and the correction unit 50 is detachably mounted on the correction station RP which is provided on the base 22.

According to the lead correction device, it is possible to cope with a component P with leads having a different shape simply by replacing the correction unit 50 installed in the correction station RP, and it is possible to obtain a lead correction device having high versatility. In addition, the number of the forming dies 55 and 55 is not limited to two, and it is possible to correct the positions of the leads P1 and P2 by one forming die.

Moreover, according to the above-described embodiment, since the forming die 55 and the drive units 67 and 68 are separately provided on the base 22, respectively, it is also possible to deal with a component P with leads having a different shape simply by exchanging the forming dies 55 and 56.

In addition, according to the above-described embodiment, since the correction unit 50 is provided on the correction unit supporting stand 51 which is detachably mounted on the slot 44 of the device stand 12a on which the tape feeder 43 of the component supply device 12 is detachably mounted, it is possible to mount the correction unit supporting stand 51 on which the correction unit 50 is mounted using the slot 44 on which the tape feeder 43 is mounted, a specific space for providing the correction station RP is not required, and thus, it is possible to reduce a space.

Moreover, according to the above-described embodiment, since the plurality of kinds of correction units 50A, 50B, and 50C are disposed on the correction unit supporting stand 51, it is possible to cope with a plurality of components P with leads of different kinds, and since the plurality kinds of correction units are disposed on one correction unit supporting stand 51, it is possible to reduce a space even when various forming shapes are performed.

In addition, according to the above-described embodiment, since the drive units 67 and 68 are configured of the drive motors 65 and 66 and the ball screw mechanisms 63 and 64 driven by the drive motors 65 and 66, it is possible to change the movement amounts (strokes) of the first and second forming dies 55 and 56 using the drive motors 65 and 66, and it is possible to arbitrarily change the bending margins of the leads P1 and P2 during the forming. Accordingly, for example, it is possible to change the bending margins of the leads P1 and P2 according to the bending amount of the lead position.

As described above, the lead correction method and the lead correction device of the present invention are described according to the embodiment. However, the present invention is not limited to the configuration described in the embodiment, and it is possible to perform various aspects within the scope of the present invention, which is defined by the Claims.

### Industrial Applicability

A lead correction method and a lead correction device according to the present invention are suitably used so as to insert leads of a component with leads into a lead insertion hole formed on a printed circuit board.

### Reference Signs List

10: component mounting device, 11 and 12: component supply device, 11a and 12a: device stand, 13: component transfer device, 15: substrate transport device, 21: base, 25: mounting head, 35: substrate imaging device, 36: component imaging device, 41: tray, 43: tape feeder, 50, 50A, 50B, and 50C: correction unit, 51: correction unit supporting stand, 55, 56, 155, 156, and 255: forming die, 65 and 66: drive motor, 67 and 68: drive unit, 70: control device, Step 104: imaging step, Step 106: determination step, Step 110: correction step, RP: correction station, P: component with leads, P1 and P2: lead, B: printed circuit board

## Claims

1. A lead correction method comprising:
an imaging step (104) of imaging a lead (P1, P2) of a component (P) with leads (P1, P2) to be mounted on a printed circuit board (B);
a determination step (106) of determining whether or not a position of the lead (P1, P2) imaged in the imaging step (104) is within an allowable tolerance; and
a correction step (110) of correcting the position of the lead (P1, P2) when it is determined that the position is outside the allowable tolerance in the determination step (106),
wherein the imaging step (104) and the determination step (106) are performed again after the correction operation in the correction step (110), and when the lead (P1, P2) position is not corrected so as to be within the allowable tolerance, the imaging step (104), the determination step (106), and the correction step (110) are repeated,
**characterized in that**
the component (P) is configured such that the lead (P1, P2) is inserted into a lead insertion hole in the printed circuit board (B) when the component is mounted on the printed circuit board (B),
the allowable tolerance is for inserting the lead (P1, P2) into the lead insertion hole, and
the imaging step (104), the determination step (106), and the correction step (110) are repeated up to a maximum number of allowable times of a correction operation which is set in advance.

2. The lead correction method according to claim 1,
wherein when the lead position is not within the allowable tolerance even though the correction operation has been performed for the maximum number of allowable times, the component (P) with leads (P1, P2) is discarded as being considered to be abnormal.

3. A lead correction device comprising:
an imaging device (36) configured to image a lead (P1, P2) of a component (P) with leads (P1, P2) to be mounted on a printed circuit board (B); a control device (70) configured to determine if a position of the lead (P1, P2) imaged by the imaging device (36) is within a range of an allowable tolerance;
a base (21);
a correction station (RP) which is provided on the base (21); and
a correction unit (50, 50A, 50B, 50C) configured to correct the position of the lead (P1, P2) when it is determined that the position of the lead (P1, P2) imaged by the imaging device (36) is outside the range of the allowable tolerance,
wherein the correction unit (50, 50A, 50B, 50C) includes a forming die (55, 56, 155, 156, 255) which is exchangeable in accordance with leads (P1, P2) having different shapes and which is configured to correct the position of the lead (P1, P2), and a drive unit (67, 68) which is configured to move the forming die (55, 56, 155, 156, 255),
wherein the correction unit (50, 50A, 50B, 50C) is configured to be detachably mounted on the correction station (RP),
wherein the component (P) is configured such that the lead (P1, P2) is inserted into a lead insertion hole in the printed circuit board (B) when the component is mounted on the printed circuit board (B),
wherein the allowable tolerance is for inserting the lead (P1, P2) into the lead insertion hole, and
wherein the lead correction device is configured to image the lead (P1, P2) after the correction operation, determine if the position of the lead (P1, P2) is corrected so as to be within the range of the allowable tolerance, and when the lead (P1, P2) position is not corrected so as to be within the allowable tolerance, repeat the correction, imaging and
determination up to a maximum number of allowable times of a correction operation which is set in advance.

4. The lead correction device according to claim 3,
wherein the forming die (55, 56, 155, 156, 255) and the drive unit (67, 68) are provided so as to be separated from the base (21).

5. The lead correction device according to claim 3,
wherein the correction (50, 50A, 50B, 50C) unit is provided on a correction unit supporting stand (51) which is detachably mounted on a slot (44) of a device stand (12a) on which a feeder (43) of a component supply device (12) is detachably mounted.

6. The lead correction device according to claim 5,
wherein a plurality of kinds of correction units (50, 50A, 50B, 50C) are disposed on the correction unit supporting stand (51).

7. The lead correction device according to claim 3,
wherein the drive unit (67, 68) includes a drive motor (65, 66), and a ball screw mechanism (63, 64) driven by the drive motor.

## Patentansprüche

1. Ein Leiterkorrekturverfahren umfassend:
einen Abbildungsschritt (104) zum Abbilden eines Leiters (P1, P2) eines Bauteils (P) mit Leitern (P1, P2), die auf einer Leiterplatte (B) montiert werden sollen;
einen Bestimmungsschritt (106) zum Bestimmen, ob eine Position des Leiters (P1, P2), der in dem Abbildungsschritt (104) abgebildet wurde, innerhalb einer zulässigen Toleranz liegt oder nicht; und
einen Korrekturschritt (110) zum Korrigieren der Position des Leiters (P1, P2), wenn im Bestimmungsschritt (106) festgestellt wird, dass die Position außerhalb der zulässigen Toleranz liegt, wobei
der Abbildungsschritt (104) und der Bestimmungsschritt (106) nach dem Korrekturvorgang in dem Korrekturschritt (110) erneut durchgeführt werden, und wenn die Position des Leiters (P1, P2) nicht so korrigiert wird, dass sie innerhalb der zulässigen Toleranz liegt, der Abbildungsschritt (104), der Bestimmungsschritt (106) und der Korrekturschritt (110) wiederholt werden,
**dadurch gekennzeichnet dass**
das Bauteil (P) so konfiguriert ist, dass der Leiter (P1, P2) in ein Leitereinführungsloch in der Leiterplatte (B) eingeführt wird, wenn das Bauteil auf der Leiterplatte (B) montiert ist,
die zulässige Toleranz für das Einführen des Leiters (P1, P2) in das Leitereinführungsloch ist, und
der Abbildungsschritt (104), der Bestimmungsschritt (106) und der Korrekturschritt (110) bis zu einer maximal zulässigen Anzahl von Malen eines Korrekturvorgangs wiederholt werden, die im Voraus festgelegt wird.

2. Das Leiterkorrekturverfahren gemäß Anspruch 1, wobei
wenn die Leiterposition nicht innerhalb der zulässigen Toleranz liegt, obwohl die Korrektur so oft wie möglich durchgeführt wurde, das Bauteil (P) mit den Leitern (P1, P2) als anormal eingestuft und verworfen wird.

3. Eine Leiterkorrekturvorrichtung umfassend:
eine Abbildungsvorrichtung (36), die konfiguriert ist einen Leiter (P1, P2) eines Bauteils (P) mit Leitern (P1, P2) abzubilden, das auf einer Leiterplatte (B) montiert werden soll
eine Steuervorrichtung (70), die konfiguriert ist, um zu bestimmen, ob eine Position des Leiters (P1, P2), der durch die Abbildungsvorrichtung (36) abgebildet wird, innerhalb eines Bereichs einer zulässigen Toleranz liegt;
eine Basis (21);
eine Korrekturstation (RP), die auf der Basis (21) angeordnet ist; und
eine Korrektureinheit (50, 50A, 50B, 50C), die konfiguriert ist, um die Position des Leiters (P1, P2) zu korrigieren, wenn festgestellt wird, dass die Position des Leiters (P1, P2), die durch die Abbildungsvorrichtung (36) abgebildet wird, außerhalb des Bereichs der zulässigen Toleranz liegt, wobei
die Korrektureinheit (50, 50A, 50B, 50C) einen Umformstempel (55, 56, 155, 156, 255), der entsprechend unterschiedlich geformter Leiter (P1, P2) austauschbar und zur Korrektur der Position des Leiters (P1, P2) ausgebildet ist, und eine Antriebseinheit (67, 68), die zur Bewegung des Umformstempels (55, 56, 155, 156, 255) ausgebildet ist, umfasst, wobei
die Korrektureinheit (50, 50A, 50B, 50C) konfiguriert ist, um abnehmbar an der Korrekturstation (RP) angebracht zu werden, wobei
das Bauteil (P) so konfiguriert ist, dass der Leiter (P1, P2) in ein Leitereinführungsloch in der Leiterplatte (B) eingeführt wird, wenn das Bauteil auf der Leiterplatte (B) montiert ist, wobei
die zulässige Toleranz für das Einführen des Leiters (P1, P2) in das Leitereinführungsloch ist, und wobei
die Leiterkorrekturvorrichtung konfiguriert ist den Leiter (P1, P2) nach dem Korrekturvorgang abzubilden, festzustellen, ob die Position des Leiters (P1, P2) so korrigiert ist, dass sie innerhalb des Bereichs der zulässigen Toleranz liegt, und, wenn die Position des Leiters (P1, P2) nicht so korrigiert ist, dass sie innerhalb der zulässigen Toleranz liegt, die Korrektur, das Abbilden und die Feststellung bis zu einer maximalen Anzahl von zulässigen Malen eines Korrekturvorgangs zu wiederholen, die im Voraus festgelegt ist.

4. Die Leiterkorrekturvorrichtung gemäß Anspruch 3, wobei
der Umformstempel (55, 56, 155, 156, 255) und die Antriebseinheit (67, 68) so angeordnet sind, dass sie von der Basis (21) getrennt werden können.

5. Die Leiterkorrekturvorrichtung gemäß Anspruch 3, wobei
die Korrektureinheit (50, 50A, 50B, 50C) auf einem Korrektureinheitenträger (51) angeordnet ist, der abnehmbar auf einem Schlitz (44) eines Geräteträger (12a) montiert ist, auf dem eine Zuführvorrichtung (43) einer Bauteilzuführvorrichtung (12) abnehmbar montiert ist.

6. Die Leiterkorrekturvorrichtung gemäß Anspruch 5, wobei
Eine Vielzahl von Arten von Korrektureinheiten (50, 50A, 50B, 50C) auf dem Korrektureinheitenträger (51) angeordnet sind.

7. Die Leiterkorrekturvorrichtung gemäß Anspruch 3, wobei
die Antriebseinheit (67, 68) einen Antriebsmotor (65, 66) und einen durch den Antriebsmotor angetriebenen Kugelumlaufspindelmechanismus (63, 64) umfasst.

## Revendications

1. Procédé de correction de broche comprenant :
une étape d'imagerie (104) d'imagerie d'une broche (P1, P2) d'un composant (P) avec des broches (P1, P2) à monter sur une carte de circuits imprimés (B) ;
une étape de détermination (106) de détermination qu'une position de la broche (P1, P2) dont l'image est capturée à l'étape d'imagerie (104) s'inscrit ou non dans une tolérance acceptable ; et
une étape de correction (110) de correction de la position de la broche (P1, P2) lorsqu'il est déterminé que la position est hors de la tolérance acceptable à l'étape de détermination (106),
dans lequel l'étape d'imagerie (104) et l'étape de détermination (106) sont exécutées à nouveau après l'opération de correction à l'étape de correction (110), et lorsque la position de broche (P1, P2) n'est pas corrigée de sorte à être inscrite dans la tolérance acceptable, l'étape d'imagerie (104), l'étape de détermination (106) et l'étape de correction (110) sont répétées,
**caractérisé en ce que**
le composant (P) est configuré de sorte que la broche (P1, P2) est insérée dans un trou d'insertion de broche dans la carte de circuits imprimés (B) lorsque le composant est monté sur la carte de circuits imprimés (B),
la tolérance acceptable est destinée à une insertion de la broche (P1, P2) dans le trou d'insertion de broche, et
l'étape d'imagerie (104), l'étape de détermination (106) et l'étape de correction (110) sont répétées jusqu'à un nombre maximal de fois acceptable d'une opération de correction qui est défini à l'avance.

2. Le procédé de correction de broche selon la revendication 1,
dans lequel lorsque la position de broche ne s'inscrit pas dans la tolérance acceptable même si l'opération de correction a été exécutée le nombre maximal de fois acceptable, le composant (P) avec des broches (P1, P2) est éliminé en étant considéré comme anormal.

3. Dispositif de correction de broche comprenant :
une étape d'imagerie (36) configurée pour capturer une image d'une broche (P1, P2) d'un composant (P) avec des broches (P1, P2) à monter sur une carte de circuits imprimés (B) ;
un dispositif de contrôle (70) configuré pour déterminer si une position de la broche (P1, P2) dont l'image est capturée par le dispositif d'imagerie (36) s'inscrit dans plage d'une tolérance acceptable ;
une base (21) ;
un poste de correction (RP) qui est installé sur la base (21) ; et
une unité de correction (50, 50A, 50B, 50C) configurée pour corriger la position de la broche (P1, P2) lorsqu'il est déterminé que la position de la broche (P1, P2) dont l'image est capturée par le dispositif d'imagerie (36) est hors de la plage de la tolérance acceptable,
dans lequel l'unité de correction (50, 50A, 50B, 50C) inclut un socle de formation (forming die) (55, 56, 155, 156, 255) qui est échangeable selon des broches (P1, P2) présentant différentes formes et qui est configuré pour corriger la position de la broche (P1, P2), et une unité d'entraînement (67, 68) qui est configurée pour déplacer le socle de formation (55, 56, 155, 156, 255),
dans lequel l'unité de correction (50, 50A, 50B, 50C) est configurée pour être montée de manière amovible sur le poste de correction (RP),
dans lequel le composant (P) est configuré de sorte que la broche (P1, P2) est insérée dans un trou d'insertion de broche dans la carte de circuits imprimés (B) lorsque le composant est monté sur la carte de circuits imprimés (B),
dans lequel la tolérance acceptable est destinée à une insertion de la broche (P1, P2) dans le trou d'insertion de broche, et
dans lequel le dispositif de correction de broche est configuré pour capturer une image de la broche (P1, P2) après l'opération de correction, déterminer si la position de la broche (P1, P2) est corrigée de sorte à s'inscrire dans la plage de la tolérance acceptable, et lorsque la position de la broche (P1, P2) n'est pas corrigée de sorte à s'inscrire dans la tolérance acceptable, répéter la correction, en capturant une image et en déterminant jusqu'à un nombre maximal de fois acceptable d'une opération de correction qui est défini à l'avance.

4. Le dispositif de correction de broche selon la revendication 3,
dans lequel le socle de formation (55, 56, 155, 156, 255) et l'unité d'entraînement (67, 68) sont disposés de sorte à être séparés de la base (21).

5. Le dispositif de correction de broche selon la revendication 3,
dans lequel l'unité de correction (50, 50A, 50B, 50C) est disposée sur un socle de support d'unité de correction (51) qui est monté de manière amovible sur un logement (44) d'un support de dispositif (12a) sur lequel un chargeur (43) d'un dispositif d'alimentation en composants (12) est monté de manière amovible.

6. Le dispositif de correction de broche selon la revendication 5,
dans lequel une pluralité de types d'unité de correction (50, 50A, 50B, 50C) est installée sur le socle de support d'unité de correction (51).

7. Le dispositif de correction de broche selon la revendication 3,
dans lequel l'unité d'entraînement (67, 68) inclut un moteur d'entraînement (65, 66), et un mécanisme de vis à billes (63, 64) entraîné par le moteur d'entraînement.
